# EUROPÄISCHE PATENTSCHRIFT

(11) **EP 3 671 151 B1**
(45) Veröffentlichungstag und Bekanntmachung des Hinweises auf die Patenterteilung: **17.07.2024**
(21) Anmeldenummer: 19215460.7
(22) Anmeldetag: 12.12.2019
(51) Int. Cl.: G01K 3/14, G01K 15/00, G01R 19/32, G01R 31/364

(54) **BATTERIESENSOR UND VERFAHREN ZUM BETRIEB EINES BATTERIESENSORS**
BATTERY SENSOR AND METHOD FOR OPERATING SAME
CAPTEUR DE BATTERIE ET PROCÉDÉ DE FONCTIONNEMENT D'UN CAPTEUR DE BATTERIE

(30) Priorität: 20.12.2018 DE 102018222438; 04.01.2019 DE 102019200062
(43) Veröffentlichungstag der Anmeldung: 24.06.2020
(73) Patentinhaber: Continental Automotive Technologies GmbH, 30175 Hannover (DE)
(72) Erfinder: Aumer, Andreas, 60488 Frankfurt am Main (DE)
(74) Vertreter: Continental Corporation

(56) Entgegenhaltungen:
- DE-A1- 102014 207 756
- DE-A1- 102014 218 708
- US-A1- 2018 328 996
- US-B2- 8 970 143

## Beschreibung

Die Erfindung betrifft einen Batteriesensor in einem Fahrzeug, wobei der Stromsensor einen zwischen einem ersten Anschlusselement und einem zweiten Anschlusselement angeordneten und mit diesen elektrisch kontaktierten Messwiderstand aufweist, wobei am ersten Anschlusselement zumindest zwei erste Kontakte und am zweiten Anschlusselement zumindest zwei zweite Kontakte vorgesehen sind, wobei eine erste Messeinrichtung mit einer ersten Strommesseinrichtung und eine zweite Messeinrichtung mit einer zweiten Strommesseinrichtung vorgesehen sind, wobei die Strommesseinrichtungen jeweils mit einem ersten Kontakt und einem zweiten Kontakt elektrisch kontaktiert sind, und wobei die erste Messeinrichtung einen ersten Temperatursensor und die zweite Messeinrichtung einen zweiten Temperatursensor aufweist, der jeweils thermisch mit dem ersten Kontakt oder dem zweiten Kontakt verbunden ist. Die Erfindung betrifft des Weiteren ein Verfahren zum Betrieb eines solchen Batteriesensors.

In vielen Anwendungen, insbesondere im Fahrzeugbereich, ist es erforderlich, die auftretenden Ströme sehr exakt zu ermitteln bzw. zu messen. Aus dem Stand der Technik sind beispielsweise Verfahren sowie Sensoren bekannt, bei welchen die Stromstärke über den Spannungsabfall über ein im Strompfad angeordneten Messwiderstand ermittelt wird. Der elektrische Widerstand des Messwiderstandes ist sehr genau bekannt. Vorzugsweise werden für den Messwiderstand spezielle Legierungen verwendet, beispielsweise eine Kupfer-Nickel-Mangan-Legierung, die sowohl eine geringe zeitliche Veränderung des elektrischen Widerstandes wie auch eine geringe Empfindlichkeit bei Temperaturänderungen aufweist.

Die Kontakte zur Erfassung des Spannungsabfalls sind üblicherweise auf den Anschlusselementen angeordnet, so dass sich die Messstrecke über den Messwiderstand sowie abschnittsweise über die Anschlusselemente erstreckt. Aus der US 8,970,143 B2 ist ein Sensor bekannt, der auf jedem der Anschlusselemente zwei Messkontakte aufweist.

Die Anschlusselemente bestehen üblicherweise aus einer Kupferlegierung und sind mit dem Messwiderstand verschweißt. Die verwendeten Kupferlegierungen haben aber eine höhere Temperaturabhängigkeit des elektrischen Widerstandes. Das Verhalten des elektrischen Widerstandes bei verschiedenen Temperaturen ist bekannt, sodass bei bekannter Temperatur der genaue elektrische Widerstand bestimmt werden kann. Zur Bestimmung der Temperatur ist zusätzlich eine Temperaturbestimmung des Batteriesensors erforderlich.

Eine Möglichkeit der Temperaturmessung besteht darin, Temperatursensoren auf dem Messwiderstand anzuordnen. Dies ist aber sehr aufwendig und teuer.

Eine weitere Möglichkeit der Temperaturmessung besteht darin, auf einer Leiterplatte, auf der eine Auswerteschaltung des Batteriesensors angeordnet ist, einen Temperatursensor anzuordnen. Dieser Temperatursensor ist mit einem thermisch leitenden Kontaktstift, über den eine Spannung an einem der Anschlusselemente erfasst wird, verbunden. Erwärmt sich der Messwiderstand bzw. das Anschlusselement, wird auch der Kontaktstift erwärmt, sodass die Temperaturänderung durch den Temperatursensor erfasst werden kann. Aus der DE 10 2014 207 756 A1 ist ein Verfahren zur Temperaturbestimmung bekannt, bei dem zwei optische Temperatursensoren auf einer gemeinsamen Leiterplatte angeordnet sind.

Aufgabe der Erfindung ist es, die Temperaturmessung innerhalb eines Batteriesensors zu verbessern.

Zur Lösung der Aufgabe ist ein Batteriesensor für eine Batterie in einem Fahrzeug vorgesehen, wobei der Stromsensor einen zwischen einem ersten Anschlusselement und einem zweiten Anschlusselement angeordneten und mit diesen elektrisch kontaktierten Messwiderstand aufweist. Am ersten Anschlusselement sind zumindest zwei erste Kontakte und am zweiten Anschlusselement zumindest zwei zweite Kontakte vorgesehen. Es sind eine erste Messeinrichtung mit einer ersten Strommesseinrichtung und eine zweite Messeinrichtung mit einer zweiten Strommesseinrichtung vorgesehen, wobei die Strommesseinrichtungen jeweils mit einem ersten Kontakt und einem zweiten Kontakt elektrisch kontaktiert sind. Die erste Messeinrichtung weist einen ersten Temperatursensor auf, der thermisch mit dem ersten Kontakt oder dem zweiten Kontakt verbunden ist, und die zweite Messeinrichtung weist einen zweiten Temperatursensor auf, der thermisch mit dem ersten Kontakt oder dem zweiten Kontakt verbunden ist. Es ist eine mit der ersten Messeinrichtung und der zweiten Messeinrichtung verbundene Auswerteschaltung zur Auswertung der von den Temperatursensoren ausgegebenen Temperatur Signale vorgesehen.

Um die Genauigkeit der Strommessung zu verbessern, weisen die Messeinrichtungen jeweils einen Temperatursensor auf. Da die Temperatursensoren jeweils mit einem separaten Kontakt mit einem der Anschlusselemente verbunden sind, messen diese an unterschiedlichen Positionen der Anschlusselemente die Temperatur. Die zwei ermittelten Temperaturen können miteinander verglichen werden, um Fehler bei der Temperaturmessung zu erfassen oder um eine Temperaturverteilung innerhalb der Anschlusselemente bzw. des Messwiderstandes zu ermitteln.

Beispielsweise ist der erste Temperatursensor mit einem ersten Kontakt und der zweite Temperatursensor mit einem zweiten Kontakt thermisch verbunden. Das heißt, der erste Temperatursensor erfasst die Temperatur des ersten Anschlusselements und der zweite Temperatursensor erfasst die Temperatur des zweiten Anschlusselements. Es werden also die Temperaturen auf beiden Seiten des Messwiderstandes erfasst. Dadurch werden zum einen die Temperaturen beider Anschlusselemente erfasst, sodass deren Temperatur und somit deren elektrischer Widerstand sehr genau bestimmt werden kann. Zum anderen kann durch die Temperaturmessung auf beiden Seiten des Messwiderstandes die Temperatur des Messwiderstandes bestimmt werden kann. Insbesondere kann auch eine Temperaturverteilung innerhalb des Messwiderstandes bestimmt werden, wodurch eine noch genauere Bestimmung des elektrischen Widerstandes des Messwiderstandes sowie der Abschnitte der Anschlusselemente möglich ist. Insbesondere ist der erste Temperatursensor thermisch mit dem ersten Anschlusselement und der zweite Temperatursensor thermisch mit dem zweiten Anschlusselement verbunden.

Der Abstand der ersten Kontakte zum Widerstandselement und/oder der Abstand der zweiten Kontakte zum Widerstandselement kann jeweils gleich groß sein. In dieser Ausführungsform sind die Messstrecken beider Messeinrichtungen gleich lang, sodass identische Messwerte zu erwarten sind. Über einen Vergleich der Messwerte beider Messeinrichtungen ist somit auch ein Abgleich beider Messwerte möglich, sodass Messfehler erkannt werden können.

In einer weiteren Ausführungsform können die ersten Kontakte zum Widerstandselement jeweils verschiedene Abstände aufweisen und/oder dass die zweiten Kontakte zum Widerstandselement jeweils verschiedene Abstände aufweisen. Die Kontakte, die mit den Temperatursensoren verbunden sind, können einen unterschiedlichen Abstand zum Messwiderstand aufweisen. Dadurch ist beispielsweise eine Bestimmung der Temperaturverteilung innerhalb des Messwiderstandes bzw. der Anschlusselemente möglich. Sind die Temperatursensoren jeweils mit einem Kontakt auf demselben Anschlusselement verbunden, ist eine Bestimmung der Temperaturverteilung innerhalb dieses Anschlusselements möglich. Des Weiteren ist eine Verifikation der erfassten Temperaturen über die Spannungsmessungen möglich. In Abhängigkeit von Abstand der Kontakte zum Messwiderstand ist die Länge des Abschnitts des Anschlusselements, der Teil der Messstrecke ist, unterschiedlich lang. Da sich der elektrische Widerstand der Anschlusselemente temperaturabhängig ändert, weichen die Messwerte der Messeinrichtungen voneinander ab. Durch diese Abweichungen bzw. die Differenz der Messwerte können weitere Aussagen über die Temperatur der Anschlusselemente bzw. die Wärmeverteilung getroffen werden.

Beispielsweise weist der erste Kontakt der ersten Messeinrichtung einen größeren Abstand zum Messwiderstand auf als der erste Kontakt der zweiten Messeinrichtung und der zweite Kontakt der zweiten Messeinrichtung weist einen höheren Abstand zum Messwiderstand auf als der zweite Kontakt der ersten Messeinrichtung. Die Messstrecke der ersten Messeinrichtung umfasst somit einen größeren Abschnitt des ersten Anschlusselements und die Messstrecke der zweiten Messeinrichtung umfasst einen größeren Abschnitt des zweiten Anschlusselements. Sind die Messstrecken insgesamt gleich lang, kann durch Vergleich der Messwerte bzw. die Differenz der Messwerte festgestellt werden, welcher der Abschnitte eine stärkere temperaturabhängige Änderung des Messwiderstandes aufweist und somit wärmer bzw. kälter ist. Insbesondere kann auch eine Temperaturdifferenz zwischen den beiden Anschlusselementen bestimmt werden. Dadurch ist beispielsweise eine Verifizierung der über die Temperatursensoren ermittelten Temperatur möglich. Insbesondere ist mit diesem Verfahren eine Kompensation von Thermospannungen, die zwischen den Anschlusselementen und dem Messwiderstand auftreten, möglich.

Die Abstände zwischen einem mit einer der Messeinrichtungen verbundenen ersten Kontakt und dem mit der gleichen Messeinrichtung verbundenen zweiten Kontakt können also jeweils gleich groß sein.

Die Abstände zwischen einem mit einer der Messeinrichtungen verbundenen ersten Kontakt und dem mit der gleichen Messeinrichtung verbundenen zweiten Kontakt können jeweils unterschiedlich groß sein, so dass die Messstrecken unterschiedlich lang sind.

Beispielsweise ist ein erster Eingang der ersten Strommesseinrichtung mit einem ersten Kontakt und ein zweiter Eingang der ersten Strommesseinrichtung mit einem zweiten Kontakt kontaktiert und ein erster Eingang der ersten Strommesseinrichtung mit einem zweiten Kontakt und ein zweiter Eingang der ersten Strommesseinrichtung mit einem ersten Kontakt kontaktiert. Das heißt, die Messeinrichtungen sind entgegengesetzt geschaltet. Durch den Vergleich beider Messwerte ist eine Verifikation der Ergebnisse der Messeinrichtung möglich. Diese müssen bis auf die Vorzeichen übereinstimmen.

Der vorstehend beschriebene Batteriesensor kann einen Messwiderstand aus einem Material aufweisen, das nur eine geringe Temperaturabhängigkeit des elektrischen Widerstands aufweist, beispielsweise eine Kupfer-Nickel-Mangan-Legierung. Der Batteriesensor kann aber auch einen Messwiderstand aus einem Material mit einer höheren Temperaturabhängigkeit aufweisen. Durch die genaue Temperaturbestimmung ist eine sehr genaue Bestimmung des elektrischen Widerstandes auch bei einer sich verändernden Temperatur des Messwiderstandes möglich, so dass auch bei einem Messwiderstand aus einem Material mit einer höheren Temperaturabhängigkeit eine ausreichende Genauigkeit der Strommessung erreicht werden kann.

Zur Lösung der Aufgabe ist des Weiteren ein Verfahren zum Betrieb eines vorstehend beschriebenen Batteriesensors vorgesehen, wobei mit dem ersten Temperatursensor ein erster Temperaturwert bestimmt wird und mit dem zweiten Temperatursensor ein zweiter Temperaturwert bestimmt wird, wobei die Temperaturwerte an die Auswerteeinheit ausgegeben werden und ein Gesamt Temperaturwert aus dem ersten Temperaturwert und dem zweiten Temperaturwert bestimmt wird.

Weitere Vorteile und Merkmale ergeben sich aus der nachfolgenden Beschreibung in Verbindung mit den beigefügten Zeichnungen. In diesen zeigen:
- Figur 1: eine perspektivische Darstellung eines Batteriesensors;
- Figur 2: eine schematische Teildarstellung des Batteriesensors aus Figur 1;
- Figur 3: eine Detailansicht des Messwiderstandes des Batteriesensors aus Figur 1 mit daran angeschlossenen Anschlusselementen;
- Figur 4: eine Detailansicht einer ersten Ausführungsform eines erfindungsgemäßen Batteriesensors;
- Figur 5: eine Detailansicht einer zweiten Ausführungsform eines erfindungsgemäßen Batteriesensors;
- Figur 6: eine Detailansicht einer dritten Ausführungsform eines erfindungsgemäßen Batteriesensors; und
- Figur 7: eine Detailansicht einer vierten Ausführungsform eines erfindungsgemäßen Batteriesensors.

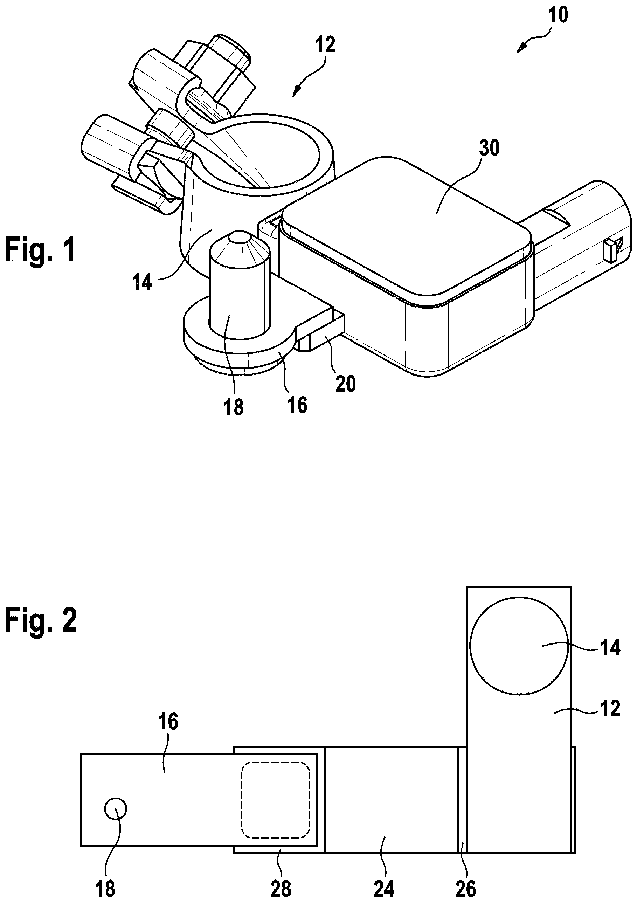

Figur 1 ist ein Batteriesensor 10 gezeigt, mit einer ersten Anschlussvorrichtung 12, die eine Batteriepolklemme 14 aufweist, einer zweiten Anschlussvorrichtung 16, die einen Kabelanschluss 18 für ein Massekabel aufweist, sowie mit einem Widerstandsbaugruppe 20, die die erste Anschlussvorrichtung 12 und die zweite Anschlussvorrichtung 16 elektrisch miteinander verbindet.

Die Widerstandsbaugruppe 20 hat, wie insbesondere in Figur 2 zu sehen ist, einen Messwiderstand 24, ein erstes Anschlusselement 26, das mit der ersten Anschlussvorrichtung 12 verbunden ist, und ein zweites Anschlusselement 28, das mit der zweiten Anschlussvorrichtung 16 verbunden ist.

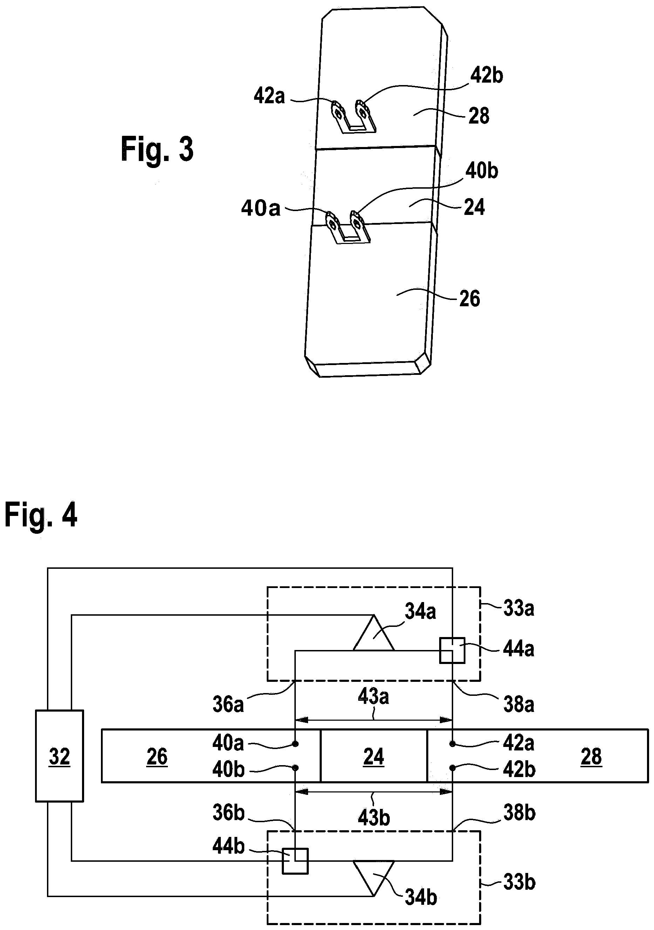

Des Weiteren weist der Batteriesensor 10 ein Gehäuse 30 auf, in dem eine nachfolgend im Detail beschriebene Auswerteschaltung 32 (siehe Figur 4) sowie zumindest zwei Messeinrichtungen 33a, 33b für Batterieparameter vorgesehen sind. In der hier gezeigten Ausführungsform weisen die Messeinrichtungen 33a, 33b zumindest eine Strommesseinrichtung 34a, 34b zur Erfassung des Batteriestroms auf.

Die Strommesseinrichtungen 34a, 34b, weisen jeweils einen ersten Eingang 36a, 36b sowie einen zweiten Eingang 38a, 38b auf. Auf dem ersten Anschlusselement 26 sind zwei erste Kontakte 40a, 40b vorgesehen, auf den zweiten Anschlusselement 28 sind zwei zweite Kontakte 42a, 42b vorgesehen.

Jeweils ein Eingang 36a, 36b, 38a, 38b einer Strommesseinrichtung 34a, 34b ist mit einem ersten Kontakt 40a, 40b kontaktiert, und jeweils ein weiterer Eingang 36a, 36b, 38a, 38b ist mit einem zweiten Kontakt 42a, 42b kontaktiert, sodass jede Strommesseinrichtung mit einem ersten Kontakt 40a, 40b und einem zweiten Kontakt 42a, 42b kontaktiert ist.

Die Strommesseinrichtungen 34a, 34b sind dazu eingerichtet über die Eingänge 36a, 38a, 36b, 38b jeweils eine Spannung zu erfassen, sodass jeweils ein Spannungsabfall zwischen einem ersten Eingang 36a, 36b und einem zweiten Eingang 38a, 38b erfasst werden kann.

Ist der elektrische Widerstand der Messstrecke 43a, 43b zwischen dem jeweiligen ersten Eingang 36a, 36b und dem jeweiligen zweiten Eingang 38a, 38b bekannt, kann mit dem erfassten Spannungsabfall über das ohmsche Gesetz der entlang der Messstrecke 43a, 43b bzw. durch den Batteriesensor fließende Batteriestrom berechnet werden.

Der Messwiderstand 24 besteht aus einem Material, das eine geringe Abhängigkeit des elektrischen Widerstandes von der Temperatur sowie eine geringe Alterungsdrift des elektrischen Widerstandes aufweist. Beispielsweise ist der Messwiderstand 24 aus einer Kupfer-Nickel-Mangan-Legierung hergestellt.

Die Anschlusselemente 26, 28 bestehen aus Kupfer oder einer Kupferlegierung, dass eine einfache Verbindung mit der ersten Anschlussvorrichtung 12 und der zweiten Anschlussvorrichtung 16 ermöglicht. Zudem lassen sich auf einer Kupferlegierung die Kontakte 40a, 40b, 42a, 42b einfacher befestigen oder herstellen. Die Temperaturabhängigkeit des elektrischen Widerstandes des verwendeten Materials ist bekannt. Ist die Temperatur bekannt, kann somit der genaue elektrische Widerstand der Anschlusselemente 26,28 und somit der elektrische Gesamtwiderstand der Messstrecke43a, 43b bestimmt werden.

Hierzu ist eine genaue Bestimmung der Temperatur entlang der Messstrecke 43a, 43b erforderlich.

Zur Temperaturerfassung weist jede der Messeinrichtungen 33a, 33b einen Temperatursensor 44a, 44b auf, der über einen der Eingänge 36a, 36b, 38a, 38b bzw. einem der Kontakte 40a, 40b, 42a, 42b mit jeweils einem der Anschlusselemente 26, 28 thermisch leitend kontaktiert ist sodass der Temperatursensor 44a, 44b jeweils die Temperatur eines der Anschlusselemente 26, 28 erfassen kann. Die Auswerteschaltung 32 kann aus den erfassten Temperaturen der Temperatursensoren 44a, 44b die Temperatur entlang der Messstrecke 43a, 43b und/oder eine Temperaturverteilung entlang der Messstrecke bestimmen.

In Figur 4 sind die ersten Kontakte 40a, 40b und die zweiten Kontakte 42a, 42b mit dem gleichen Abstand zum Messwiderstand 24 angeordnet. Die Messstrecken 43a, 43b sind somit gleich lang und weisen jeweils gleiche Anteile entlang des Widerstandselements 24 sowie entlang der Anschlusselemente 26,28 auf. Der elektrische Widerstand beider Messstrecken 43a, 43b ist somit, insbesondere bei gleichmäßiger Temperaturverteilung, innerhalb der Widerstandsbaugruppe 20 gleich groß.

Die ersten Eingänge 36a, 36b der Strommesseinrichtungen 34a, 34b sind jeweils mit den ersten Kontakten 40a, 40b kontaktiert, die zweiten Eingänge 38a, 38b sind jeweils mit den zweiten Kontakten 42a, 42b kontaktiert. Die mit den Strommesseinrichtungen 34a, 34b erfassten Spannungen müssen also, da der elektrische Widerstand bei der Messstrecke 43a, 43b gleich groß ist, übereinstimmen. Dies kann genutzt werden, um die Strommesseinrichtungen 34a, 34b gegeneinander abzugleichen und/oder zu kalibrieren.

Wie in Figur 4 des Weiteren zu sehen ist, ist der erste Temperatursensor 44a mit dem zweiten Eingang 38a und somit mit dem zweiten Kontakt 42a verbunden. Der erste Temperatursensor 44a erfasst somit die Temperatur auf dem zweiten Anschlusselement 28. Der zweite Temperatursensor 44b ist mit dem ersten Eingang 36a und somit mit dem ersten Kontakt 40b verbunden. Der zweite Temperatursensor 44b erfasst somit die Temperatur auf dem ersten Anschlusselement 26.

Mit den beiden Temperatursensoren 44a, 44b wird also die Temperatur auf beiden Seiten des Messwiderstandes 24 erfasst und an die Auswerteschaltung 32 ausgegeben. Dadurch ist eine Temperaturbestimmung entlang der gesamten Messstrecken 43a, 43b möglich. Messen beide Temperatursensoren 44a, 44b die gleiche oder eine ähnliche Temperatur, kann beispielsweise davon ausgegangen werden, dass diese entlang der gesamten Messstrecke herrscht. Messen beide Temperatursensoren 44a, 44b unterschiedliche Temperaturen, kann aus diesen Temperaturen auf die Temperaturverteilung entlang der Messstrecken 43a, 43b geschlossen werden. Insgesamt ist eine sehr genaue Temperaturbestimmung entlang der Messstrecken 43a, 43b möglich.

Alternativ können auch beide Temperatursensoren 44a, 44b mit ersten Kontakten 40a, 40b oder mit zweiten Kontakten 42a, 42b kontaktiert sein, sodass beide Temperatursensoren 44a, 44b die Temperaturen auf demselben Anschlusselement 26, 28 und im gleichen Abstand zum Messwiderstand 24 erfassen. Die Temperaturen können verwendet werden, um die Temperatursensoren 44a, 44b gegen einander zu prüfen und zu kalibrieren.

In beiden vorstehend genannten Ausführungsformen ist es auch möglich, den ersten Eingang 36a, 36b und den zweiten Eingang 38a, 38b einer Strommesseinrichtung 34a, 34b zu vertauschen, sodass diese die Spannung entlang der Messstrecke mit umgekehrtem Vorzeichen erfasst.

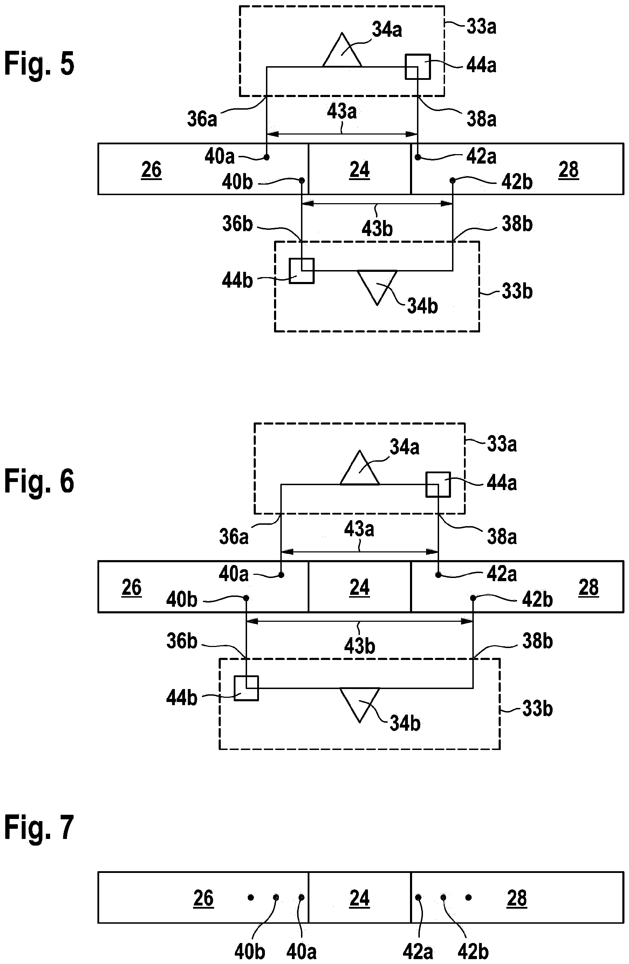

Eine weitere Ausführungsform eines Batteriesensors 10 ist in Figur 5 dargestellt. Die ersten Kontakte 36a, 36b sowie die zweiten Kontakte 38a, 38b weisen hier jeweils unterschiedliche Abstände zum Messwiderstand 24 auf, wobei die Länge der Messstrecken 43a, 43b gleich lang ist. Die Messstrecken 43a, 43b sind gewissermaßen in Stromrichtung versetzt angeordnet. Die Beschaltung der Strommesseinrichtungen 34a, 34b entspricht der in Figur 4 gezeigten Beschaltung. Die Temperaturen der Anschlusselemente 26,28 können dementsprechend auf die vorstehend beschriebene Art bestimmt werden.

Kommt es zu einer ungleichmäßigen Erwärmung der Anschlusselemente 26, 28 weisen diese unterschiedliche elektrische Widerstände auf. Die erste Messstrecke 43a der ersten Strommesseinrichtung 34a weist einen größeren Anteil des ersten Anschlusselements 26 als die zweite Messstrecke 43b der zweiten Strommesseinrichtung auf. Die zweite Messstrecke 43b der zweiten Strommesseinrichtung 34b weist einen größeren Anteil des zweiten Anschlusselements 28 auf. Die durch die unterschiedlichen Temperaturen hervorgerufenen unterschiedlichen elektrischen Widerstände wirken sich somit unterschiedlich auf den Gesamtwiderstand der ersten Messstrecke 43a und der zweiten Messstrecke 43b aus sodass mit den Strommesseinrichtungen 34a, 34b unterschiedliche Spannungsabfälle entlang der Messstrecken 43a, 43b erfasst werden..

Die unterschiedlichen Spannungsabfälle können dazu verwendet werden, um eine Temperaturverteilung entlang der Widerstandsbaugruppe 20 zu bestimmen wobei aufgrund der unterschiedlichen Spannungsabfälle und der daraus folgenden unterschiedlichen elektrischen Widerstände der Messstrecken 43a, 43b auf die Richtung des Temperaturgefälles geschlossen werden kann.

Da die Temperaturabhängigkeit des Materials der Anschlusselemente 26, 28 bekannt ist, ist es sogar möglich, die Temperaturdifferenz zwischen dem ersten Anschlusselement 26 und den zweiten Anschlusselement 28 und somit eine relative Temperaturverteilung entlang der Messstrecken 43a, 43b zu bestimmen.

Mit den Temperaturen, die von den Temperatursensoren 44a, 44b erfasst werden, ist eine noch genauere Erfassung der Temperaturen sowie des Temperaturverlaufs entlang der Messstrecken 43a, 43b möglich. Insbesondere können beispielsweise mit der ermittelten Temperaturdifferenz die mit den Temperatursensoren 44a, 44b erfassten Temperaturen geprüft werden.

In der in Figur 6 gezeigten Ausführungsform des Batteriesensors 10 sind die Abstände des ersten Kontakts 36a, und des zweiten Kontakts 38a der ersten Strommesseinrichtung 34a kleiner als die Abstände des ersten Kontakts 36b und des zweiten Kontakts 38b der zweiten Strommesseinrichtung 34b. Die erste Messstrecke 43a ist somit kürzer als die zweite Messstrecke 43b. Die Beschaltung der Strommesseinrichtungen 34a, 34b entspricht der in Figur 4 gezeigten Beschaltung. Die Temperaturen der Anschlusselemente 26, 28 können dementsprechend auf die vorstehend beschriebene Art bestimmt werden, wobei die Temperatursensoren 44a, 44b die Temperatur in unterschiedlichen Abständen zum Messwiderstand 24 erfassen.

Die in Figur 7 gezeigte Ausführungsform eines Batteriesensors 10 entspricht im Wesentlichen der in Figur 6 gezeigten Ausführungsform, wobei die ersten Kontakte 40a, 40b und die zweiten Kontakte 42a, 42b in Stromrichtung hintereinander angeordnet sind.

In allen vorstehend beschriebenen Ausführungsformen wird mit zwei Messeinrichtungen 33a, 33b eine Temperatur jeweils zumindest eines Anschlusselements 26, 28 bestimmt, wobei in der Auswerteschaltung 32 aus diesem Temperaturen die Temperatur bzw. die Temperaturverteilung entlang der Messstrecke 43a, 43b bestimmt wird, sodass eine wesentlich genauere Temperaturbestimmung möglich ist.

### Bezugszeichenliste

- 10: Batteriesensor
- 12: erste Anschlussvorrichtung
- 14: Batteriepolklemme
- 16: zweite Anschlussvorrichtung
- 18: Kabelanschluss
- 20: Widerstandsbaugruppe
- 24: Messwiderstand
- 26: erstes Anschlusselement
- 28: zweites Anschlusselement
- 30: Gehäuse
- 32: Auswerteschaltung
- 33a: erste Messeinrichtung
- 33b: zweite Messeinrichtung
- 34a: erste Strommesseinrichtung
- 34b: zweite Strommesseinrichtung
- 36a: erster Eingang der ersten Strommesseinrichtung
- 36b: erster Eingang der zweiten Strommesseinrichtung
- 38a: zweiter Eingang der ersten Strommesseinrichtung
- 38b: zweite Eingang der zweiten Strommesseinrichtung
- 40a: erster Kontakt
- 40b: erster Kontakt
- 42a: zweiter Kontakt
- 42b: zweiter Kontakt
- 43a: erste Messstrecke
- 43b: zweite Messstrecke
- 44a: erster Temperatursensor
- 44b: zweiter Temperatursensor

## Patentansprüche

1. Batteriesensor (10) für ein Fahrzeug, wobei der Batteriesensor (10) einen zwischen einem ersten Anschlusselement (26) und einem zweiten Anschlusselement (28) angeordneten und mit diesen elektrisch kontaktierten Messwiderstand (24) aufweist, wobei am ersten Anschlusselement (26) zumindest zwei erste Kontakte (40a, 40b) und am zweiten Anschlusselement (28) zumindest zwei zweite Kontakte (42a, 42b) vorgesehen sind, wobei eine erste Messeinrichtung (33a) mit einer ersten Strommesseinrichtung (34a) und eine zweite Messeinrichtung (33b) mit einer zweiten Strommesseinrichtung (34b) vorgesehen sind, wobei die Strommesseinrichtungen (34a, 34b) jeweils mit einem ersten Kontakt (40a, 40b) und einem zweiten Kontakt (40a, 40b) elektrisch kontaktiert sind, **dadurch gekennzeichnet, dass** die erste Messeinrichtung (33a) einen ersten Temperatursensor (44a) aufweist, der thermisch mit einem ersten Kontakt (40a) oder einem zweiten Kontakt (42a) verbunden ist, und die zweite Messeinrichtung (33b) einen zweiten Temperatursensor (44b) aufweist, der thermisch mit einem ersten Kontakt (40b) oder einem zweiten Kontakt (42b) verbunden ist, und dass eine mit der ersten Messeinrichtung (33a) und der zweiten Messeinrichtung (33b) verbundene Auswerteschaltung (32) zur Auswertung der von den Temperatursensoren (44a, 44b) ausgegebenen Temperatursignale vorgesehen ist.

2. Batteriesensor nach Anspruch 1, **dadurch gekennzeichnet, dass** der erste Temperatursensor (44a) mit einem ersten Kontakt (40a) und der zweite Temperatursensor (44b) mit einem zweiten Kontakt (42b) thermisch verbunden ist.

3. Batteriesensor nach einem der Ansprüche 1 und 2, **dadurch gekennzeichnet, dass** der erste Temperatursensor (44a) thermisch mit dem ersten Anschlusselement (26) und der zweite Temperatursensor (44b) thermisch mit dem zweiten Anschlusselement (28) verbunden ist.

4. Batteriesensor nach einem der Ansprüche 1 bis 3, **dadurch gekennzeichnet, dass** der Abstand der ersten Kontakte (40a, 40b) zum Messwiderstand (24) und/oder der Abstand der zweiten Kontakte (42a, 42b) zum Messwiderstand (24) jeweils gleich groß ist.

5. Batteriesensor nach einem der Ansprüche 1 bis 3, **dadurch gekennzeichnet, dass** die ersten Kontakte (40a, 40b) zum Messwiderstand (24) jeweils verschiedene Abstände aufweisen und/oder dass die zweiten Kontakte (42a, 42b) zum Messwiderstand (24) jeweils verschiedene Abstände aufweisen.

6. Batteriesensor nach einem der vorhergehenden Ansprüche, **dadurch gekennzeichnet, dass** die Abstände zwischen einem mit einer der Messeinrichtungen (33a, 33b) verbundenen ersten Kontakt (40a, 40b) und dem mit der gleichen Messeinrichtung (33a, 33b) verbundenen zweiten Kontakt (42a, 42b) jeweils gleich groß sind.

7. Batteriesensor nach einem der Ansprüche 1 bis 5, **dadurch gekennzeichnet, dass** die Abstände zwischen einem mit einer der Messeinrichtungen (33a, 33b) verbundenen ersten Kontakt (40a, 40b) und dem mit der gleichen Messeinrichtung (33a, 33b) verbundenen zweiten Kontakt (42a, 42b) jeweils unterschiedlich groß sind.

8. Batteriesensor nach einem der vorhergehenden Ansprüche, **dadurch gekennzeichnet, dass** ein erster Eingang (36a) der ersten Messeinrichtung (33a) mit einem ersten Kontakt (40a) und ein zweiter Eingang (38a) der ersten Messeinrichtung (33a) mit einem zweiten Kontakt (42a) kontaktiert ist und ein erster Eingang (40b) der zweiten Messeinrichtung (33b) mit einem zweiten Kontakt (42b) und ein zweiter Eingang (38b) der zweiten Messeinrichtung (33b) mit einem ersten Kontakt (40b) kontaktiert ist.

9. Verfahren zum Betrieb eines Batteriesensors (10) nach einem der vorhergehenden Ansprüche, wobei mit der ersten Messeinrichtung (33a) ein erster Temperaturwert bestimmt wird und mit der zweiten Messeinrichtung (33b) ein zweiter Temperaturwert bestimmt wird, wobei die Temperaturwerte an die Auswerteeinheit (32) ausgegeben werden und ein Gesamttemperaturwert und/oder eine Temperaturverteilung aus dem ersten Temperaturwert und dem zweiten Temperaturwert bestimmt wird.

## Claims

1. Battery sensor (10) for a vehicle, wherein the battery sensor (10) comprises a measurement resistor (24), which is arranged between a first connection element (26) and a second connection element (28) and is electrically contacted thereby, wherein at least two first contacts (40a, 40b) are provided at the first connection element (26) and at least two second contacts (42a, 42b) are provided at the second connection element (28), wherein a first measurement device (33a) is provided with a first current measurement device (34a) and a second measurement device (33b) is provided with a second current measurement device (34b), wherein the current measurement devices (34a, 34b) are each in electrical contact with a first contact (40a, 40b) and a second contact (40a, 40b), **characterized in that** the first measurement device (33a) has a first temperature sensor (44a), which is thermally connected to a first contact (40a) or a second contact (42a), and the second measurement device (33b) has a second temperature sensor (44b), which is thermally connected to a first contact (40b) or a second contact (42b), and **in that** an evaluation circuit (32), connected to the first measurement device (33a) and the second measurement device (33b), for evaluating the temperature signals output by the temperature sensors (44a, 44b) is provided.

2. Battery sensor according to Claim 1, **characterized in that** the first temperature sensor (44a) is thermally connected to a first contact (40a) and the second temperature sensor (44b) is thermally connected to a second contact (42b).

3. Battery sensor according to either of Claims 1 and 2, **characterized in that** the first temperature sensor (44a) is thermally connected to the first connection element (26) and the second temperature sensor (44b) is thermally connected to the second connection element (28).

4. Battery sensor according to any of Claims 1 to 3, **characterized in that** the distance between the first contact (40a, 40b) and the measurement resistor (24) and/or the distance between the second contact (42a, 42b) and the measurement resistor (24) are of equal size in each case.

5. Battery sensor according to any of Claims 1 to 3, **characterized in that** the first contacts (40a, 40b) have different distances in each case from the measurement resistor (24) and/or **in that** the second contacts (42a, 42b) have different distances in each case from the measurement resistor (24).

6. Battery sensor according to any of the preceding claims, **characterized in that** the distances between a first contact (40a, 40b), which is connected to one of the measurement devices (33a, 33b), and the second contact (42a, 42b), which is connected to the same measurement device (33a, 33b), are of equal size in each case.

7. Battery sensor according to any of Claims 1 to 5, **characterized in that** the distances between a first contact (40a, 40b), which is connected to one of the measurement devices (33a, 33b), and the second contact (42a, 42b), which is connected to the same measurement device (33a, 33b), differ in size in each case.

8. Battery sensor according to any of the preceding claims, **characterized in that** a first input (36a) of the first measurement device (33a) is in contact with a first contact (40a) and a second input (38a) of the first measurement device (33a) is in contact with a second contact (42a), and a first input (40b) of the second measurement device (33b) is in contact with a second contact (42b) and a second input (38b) of the second measurement device (33b) is in contact with a first contact (40b).

9. Method for operating a battery sensor (10) according to any of the preceding claims, wherein a first temperature value is determined using the first measurement device (33a) and a second temperature value is determined using the second measurement device (33b), wherein the temperature values are output to the evaluation unit (32) and an overall temperature value and/or a temperature distribution is determined from the first temperature value and the second temperature value.

## Revendications

1. Capteur de batterie (10) pour véhicule, dans lequel le capteur de batterie (10) comporte une résistance de mesure (24) disposée entre un premier élément de raccordement (26) et un second élément de raccordement (28) et en contact électrique avec ceux-ci, dans lequel il est prévu au moins deux premiers contacts (40a, 40b) sur le premier élément de raccordement (26) et au moins deux seconds contacts (42a, 42b) sur le second élément de raccordement (28), dans lequel il est prévu un premier dispositif de mesure (33a) comprenant un premier dispositif de mesure de courant (34a) et un second dispositif de mesure (33b) comprenant un second dispositif de mesure de courant (34b), dans lequel les dispositifs de mesure de courant (34a, 34b) sont respectivement en contact électrique avec un premier contact (40a, 40b) et un second contact (40a, 40b), **caractérisé en ce que** le premier dispositif de mesure (33a) comporte un premier capteur de température (44a) qui est relié thermiquement à un premier contact (40a) ou à un second contact (42a), et le second dispositif de mesure (33b) comporte un second capteur de température (44b) qui est relié thermiquement à un premier contact (40b) ou à un second contact (42b), et **en ce qu'**il est prévu un circuit d'évaluation (32) relié au premier dispositif de mesure (33a) et au second dispositif de mesure (33b) pour évaluer les signaux de température délivrés en sortie par les capteurs de température (44a, 44b).

2. Capteur de batterie selon la revendication 1, **caractérisé en ce que** le premier capteur de température (44a) est relié thermiquement à un premier contact (40a) et le second capteur de température (44b) est relié thermiquement à un second contact (42b).

3. Capteur de batterie selon l'une des revendications 1 et 2, **caractérisé en ce que** le premier capteur de température (44a) est relié thermiquement au premier élément de raccordement (26) et le second capteur de température (44b) est relié thermiquement au second élément de raccordement (28).

4. Capteur de batterie selon l'une des revendications 1 à 3, **caractérisé en ce que** la distance entre les premiers contacts (40a, 40b) et la résistance de mesure (24) et/ou la distance entre les seconds contacts (42a, 42b) et la résistance de mesure (24) sont respectivement de même valeur.

5. Capteur de batterie selon l'une des revendications 1 à 3, **caractérisé en ce que** les premiers contacts (40a, 40b) présentent respectivement des distances différentes par rapport à la résistance de mesure (24) et/ou **en ce que** les seconds contacts (42a, 42b) présentent respectivement des distances différentes par rapport à la résistance de mesure (24).

6. Capteur de batterie selon l'une des revendications précédentes, **caractérisé en ce que** les distances entre un premier contact (40a, 40b) relié à l'un des dispositifs de mesure (33a, 33b) et le second contact (42a, 42b) relié au même dispositif de mesure (33a, 33b) sont respectivement de même valeur.

7. Capteur de batterie selon l'une des revendications 1 à 5, **caractérisé en ce que** les distances entre un premier contact (40a, 40b) relié à l'un des dispositifs de mesure (33a, 33b) et le second contact (42a, 42b) relié au même dispositif de mesure (33a, 33b) sont respectivement de valeurs différentes.

8. Capteur de batterie selon l'une des revendications précédentes, **caractérisé en ce qu'**une première entrée (36a) du premier dispositif de mesure (33a) est en contact avec un premier contact (40a) et une seconde entrée (38a) du premier dispositif de mesure (33a) est en contact avec un second contact (42a), et une première entrée (40b) du second dispositif de mesure (33b) est en contact avec un second contact (42b) et une seconde entrée (38b) du second dispositif de mesure (33b) est en contact avec un premier contact (40b).

9. Procédé de fonctionnement d'un capteur de batterie (10) selon l'une des revendications précédentes, dans lequel une première valeur de température est déterminée à l'aide du premier dispositif de mesure (33a) et une seconde valeur de température est déterminée à l'aide du second dispositif de mesure (33b), dans lequel les valeurs de température sont délivrées en sortie à l'unité d'évaluation (32) et une valeur de température totale et/ou une répartition de température est déterminée à partir de la première valeur de température et de la seconde valeur de température.
